# EUROPÄISCHE PATENTSCHRIFT

(11) **EP 3 895 508 B1**
(45) Veröffentlichungstag und Bekanntmachung des Hinweises auf die Patenterteilung: **17.09.2025**
(21) Anmeldenummer: 19821435.5
(22) Anmeldetag: 10.12.2019
(51) Int. Cl.: H05K 1/02, B01J 19/12, H05K 3/00, H05K 3/34

(54) **VORRICHTUNG ZUR ABGABE VON LICHT**
DEVICE FOR EMITTING LIGHT
DISPOSITIF D'ÉMISSION DE LUMIÈRE

(30) Priorität: 13.12.2018 AT 511042018
(43) Veröffentlichungstag der Anmeldung: 20.10.2021
(73) Patentinhaber: Kübel, Johann, 3072 Kasten (AT); Zinner, Gerald, 3072 Kasten (AT)
(72) Erfinder: Kübel, Johann, 3072 Kasten (AT); Zinner, Gerald, 3072 Kasten (AT)
(74) Vertreter: Wildhack & Jellinek Patentanwälte GmbH
(86) Internationale Anmeldenummer: PCT/AT2019/060432
(87) Internationale Veröffentlichungsnummer: WO 2020/118339

(56) Entgegenhaltungen:
- DE-A1- 102008 031 262
- US-A1- 2011 261 536
- US-A1- 2012 307 505
- US-A1- 2018 070 436
- US-B2- 9 605 812

## Beschreibung

Die Erfindung betrifft eine Vorrichtung und eine Anordnung zur Abgabe von Licht, insbesondere zum Aushärten von unter Einstrahlung von Licht, insbesondere UV-Licht, härtenden Substanzen gemäß Patentanspruch 1 bzw. Patentanspruch 8.

Aus dem Stand der Technik ist es bekannt, mit Hilfe von energiereicher Strahlung flüssige Beschichtungswerkstoffe wie z.B. Klebstoffe, Lacke oder Farben rasch auszuhärten. Als Strahlungsquellen hierfür dienen üblicherweise spezielle Beleuchtungskörper, die UV-Licht, insbesondere UV-A-Licht, abgeben. Gängige derartige UV-Lampen sind beispielsweise Quecksilberdampflampen. Weiters stehen UV-Leuchtdioden für derartige Anwendungen zur Verfügung. Diese bieten als Vorteile, dass sie quecksilberfrei und besonders klein ausgestaltet sind, sodass sie nur einen geringen Platzbedarf aufweisen. Werden derartige Leuchtdioden jedoch über einen längeren Zeitraum betrieben, erwärmen sie sich stark, sodass es zu einer Überhitzung und Beschädigung der Leuchtdioden kommen kann.

US 2012/307505 A1 offenbart den Oberbegriff von Anspruch 1.

US 2018/070436 A1 und US 9 605 812 B2 offenbaren Vorrichtungen zur Abgabe von Licht mit einem Heißleiter.

Aufgabe der Erfindung ist es daher, eine Vorrichtung zur Abgabe von Licht bereitzustellen, die über einen längeren Zeitraum eine Lichtabgabe von einem Beleuchtungskörper gewährleistet, ohne dass die Gefahr einer Überhitzung des Beleuchtungskörpers besteht.

Die Erfindung löst diese Aufgabe mit einer Vorrichtung zur Abgabe von Licht, insbesondere zum Aushärten von unter Einstrahlung von Licht, insbesondere UV-Licht, härtenden Substanzen, mit den Merkmalen des Patentanspruchs 1.

Eine besonders energiesparende Ausgestaltung der Vorrichtung zur Abgabe von Licht kann sichergestellt werden, wenn der Beleuchtungskörper eine Leuchtdiode umfasst, die zur Abgabe von UV-Licht, insbesondere von UV-A-Licht, vorzugsweise in einem Wellenlängenbereich von 315 bis 380 nm, ausgebildet ist. Die Verwendung einer Leuchtdiode als Beleuchtungskörper ist nicht nur aufgrund deren vergleichsweise niedrigen Stromverbrauchs vorteilhaft, sondern auch weil Leuchtdioden eine vergleichsweise lange Lebensdauer aufweisen und sich durch eine besonders kleine und kompakte Bauweise auszeichnen.

Eine besonders kompakte und stabile Bauweise kann bei einer erfindungsgemäßen Vorrichtung zur Abgabe von Licht erzielt werden, wenn das Trägerelement als Leiterplatte ausgebildet ist.

Um eine einfache Verbindung der Kontakte des Heißleiters mit den elektrischen Kontakten des Beleuchtungskörpers zu gewährleisten, ist erfindungsgemäß vorgesehen, dass das Trägerelement zumindest zwei Durchlässe aufweist, wobei die zwei Kontakte, insbesondere Kontaktstifte des Heißleiters durch die Durchlässe an die elektrischen Anschlüsse des Beleuchtungskörpers geführt sind.

Um zu gewährleisten, dass im Beleuchtungskörper entstehende Wärmeenergie möglichst rasch abgeleitet wird, kann vorgesehen sein, dass der Kühlkörper aus Kupfer oder einer Kupferlegierung ausgebildet ist.

Ein müheloser Einbau einer erfindungsgemäßen Vorrichtung zur Abgabe von Licht als Bauteil in beispielsweise Industrierobotern kann sichergestellt werden, wenn der Kühlkörper zumindest eine Anschlussstelle zur Ausbildung einer stoffschlüssigen Verbindung, insbesondere durch Löten oder Kleben, in seinem vom Heißleiter abgewandten Bereich aufweist.

Ein besonders effizienter Abtransport von am Beleuchtungskörper entstehender Wärmeenergie ist gewährleistet, wenn die Verbindung zwischen dem Heißleiter und dem Kühlkörper mittels eines wärmeleitenden und elektrisch isolierenden Verbindungsmittels, insbesondere eines Klebstoffs, vorzugsweise eines hochtemperaturbeständigen wärmeleitfähigen Klebstoffs, hergestellt ist.

Um einen besonders effizienten Wärmeübergang von der thermischen Kontaktfläche des Beleuchtungskörpers auf den Kühlkörper sicherzustellen, kann vorgesehen sein, dass der Kühlkörper einen Vorsprung aufweist, wobei der Vorsprung in seiner Form und Höhe an die Form und Höhe der Ausnehmung im Trägerelement angepasst ist, sodass der Vorsprung durch die Ausnehmung hindurch an die thermische Kontaktfläche des Beleuchtungskörpers geführt ist und flächig mit der thermischen Kontaktfläche in Kontakt steht. Diese Ausgestaltung des Kühlkörpers ist z.B. besonders vorteilhaft, wenn Hochleistungsleuchtdioden als Beleuchtungskörper als Beleuchtungskörper eingesetzt werden, da diese eine im Vergleich zu herkömmlichen Leuchtdioden erhöhte Abgabe von Wärmeenergie aufweisen.

Die Erfindung betrifft weiters eine Anordnung zur Abgabe von Licht, insbesondere zum Aushärten von unter Einstrahlung von Licht, insbesondere UV-Licht, härtenden Substanzen. Erfindungsgemäß sind dabei vorgesehen, eine Vielzahl an erfindungsgemäßen Vorrichtungen zur Abgabe von Licht, eine Stromquelle zur Versorgung der Vorrichtungen mit Strom, und einen der Stromquelle nachgeschalteten Treiber, wobei die Vorrichtungen in Serie geschaltet und an den Treiber angeschlossen sind und wobei der Treiber dazu ausgebildet ist, einen konstanten Stromfluss durch die Vorrichtungen einzustellen.

Mit einer erfindungsgemäßen Anordnung kann vorteilhafterweise ein besonders rasches Aushärten beispielsweise von UV-härtenden Klebstoffen auch auf größeren Flächen erzielt werden, da durch die gemeinsame Verschaltung von einer Anzahl von Vorrichtungen die Leistung der Anordnung im Vergleich zur Leistung einer einzigen Vorrichtung vervielfacht werden kann.

Weitere Vorteile und Ausgestaltungen der Erfindung ergeben sich aus der Beschreibung und den beiliegenden Zeichnungen.

Die Erfindung ist im Folgenden anhand von besonders vorteilhaften, aber nicht einschränkend zu verstehenden Ausführungsbeispielen in den Zeichnungen schematisch dargestellt und wird unter Bezugnahme auf die Zeichnungen beispielhaft beschrieben.

Im Folgenden zeigen schematisch:
Fig. 1 eine Seitenansicht eines Ausführungsbeispiels einer erfindungsgemäßen Vorrichtung zur Abgabe von Licht,
Fig. 2 eine zweite Seitenansicht der Vorrichtung aus Fig. 1,
Fig. 3 eine Draufsicht auf die Vorrichtung aus Fig. 1,
Fig. 4 eine Explosionsdarstellung der Vorrichtung aus Fig. 1 und
Fig. 5 eine Schrägansicht der Vorrichtung aus Fig. 1.

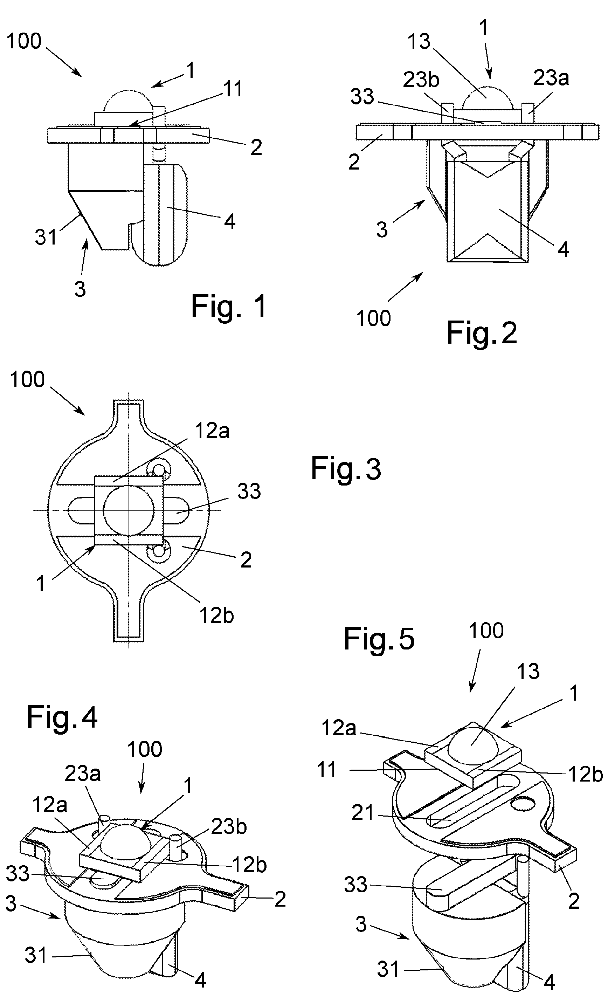

In den Fig. 1 bis Fig. 5 ist ein Ausführungsbeispiel einer erfindungsgemäßen Vorrichtung 100 zur Abgabe von Licht dargestellt. Im gezeigten Ausführungsbeispiel umfasst die Vorrichtung 100 einen elektrischen Beleuchtungskörper 1 mit einer thermischen Kontaktfläche 11 und zwei elektrischen Anschlüssen 12a, 12b. Der Beleuchtungskörper 1 ist auf einem Trägerelement 2 angeordnet und über die thermische Kontaktfläche 11 wird bei der Lichtabgabe entstehende Wärmeenergie vom Beleuchtungskörper 1 abgeleitet. Dazu weist das Trägerelement 2 im Bereich der thermischen Kontaktfläche 11 des Beleuchtungskörpers 1 eine Ausnehmung 21 auf.

Die Ausnehmung 21 weist im gezeigten Ausführungsbeispiel eine längliche Form auf, kann aber alternativ dazu auch z. B. eine runde Form aufweisen. Weiters kann anstelle einer Ausnehmung 21 auch eine Vielzahl an Ausnehmungen 21, die im Bereich der thermischen Kontaktfläche 11 z. B. hintereinander angeordnet sind, vorhanden sein.

Im gezeigten Ausführungsbeispiel umfasst die Vorrichtung 100 weiters einen Kühlkörper 3, der mit der thermischen Kontaktfläche 11 des Beleuchtungskörpers 1 im Bereich der Ausnehmung 21 im Trägerelement 2 wärmeleitend verbunden ist. Auf diese Weise wird im Beleuchtungskörper 1 entstehende Wärmeenergie über die Kontaktfläche 11 an den Kühlkörper 3 abgegeben.

Die Vorrichtung 100 umfasst weiters einen Heißleiter 4, der mit den elektrischen Anschlüssen 12a, 12b des Beleuchtungskörpers elektrisch leitend verbunden ist. Der Heißleiter 4 ist dabei mit dem Kühlkörper 3 wärmeleitend verbunden und gleichzeitig gegenüber dem Kühlkörper 3 elektrisch isoliert.

Eine derartige Vorrichtung 100 zur Abgabe von Licht kann beispielsweise dazu verwendet werden, unter Einstrahlung von Licht wie beispielsweise UV-Licht härtende Substanzen auszuhärten. Beim gezeigten Ausführungsbeispiel ist dabei in diesem Zusammenhang besonders vorteilhaft, dass die Vorrichtung 100 als Beleuchtungskörper 1 eine Leuchtdiode 13 umfasst. Auf diese Weise kann die Vorrichtung 100 besonders klein und kompakt ausgeführt werden, sodass sie im Vergleich zu bisher bekannten Quecksilberdampflampen, die für das Aushärten von Stoffen verwendet werden, nicht nur ohne Quecksilber auskommt, sondern auch einen wesentlich geringeren Platzbedarf aufweist und somit einfach als Bauteil z.B. in Robotern eingebaut werden kann.

Im gezeigten Ausführungsbeispiel handelt es sich beim Beleuchtungskörper 1 bzw. bei der Leuchtdiode 13 konkret um eine UV-Leuchtdiode, die zur Abgabe von UV-A-Licht in einem Wellenlängenbereich von 315 bis 380 nm ausgebildet ist. Der Halbleiterkristall der Leuchtdiode 13 ist dabei im gezeigten Ausführungsbeispiel auf einem quadratischen Substrat aufgebracht, das eine Kantenlänge von wenigen Millimetern, beispielsweise 3 mm, aufweist, wie dies in Fig. 3 bis Fig. 5 ersichtlich ist.

Dieser Beleuchtungskörper 1 ist auf einem Trägerelement 2 angeordnet, das als Leiterplatte ausgebildet ist und im Bereich der thermischen Kontaktfläche 11 des Beleuchtungskörpers 1, der sich auf der Unterseite des Substrats befindet, eine längliche Ausnehmung 21 aufweist, wie dies in Fig. 3 zu erkennen ist.

Die elektrischen Anschlüsse 12a, 12b des elektrischen Beleuchtungskörpers 1 sind im gezeigten Ausführungsbeispiel seitlich am Substrat der Leuchtdiode 13 angeordnet und das Trägerelement 2 weist erfindungsgemäß zwei Durchlässe 23a, 23b auf, durch die die Kontakte des Heißleiters 4 an die elektrischen Anschlüsse 12a, 12b des Beleuchtungskörpers 1 geführt sind (siehe Fig. 3, Fig. 5). Im gezeigten Ausführungsbeispiel weist der Heißleiter 4 zwei Kontaktstifte 41a, 41b auf, die durch die rund ausgeführten Durchlässe 23a, 23b im Trägerelement 2 hindurchreichen und an die elektrischen Anschlüsse 12a, 12b geführt sind (siehe Fig. 2, Fig. 5).

Alternativ dazu kann, je nach Anwendungsbereich, bei einer erfindungsgemäßen Vorrichtung 100 der Beleuchtungskörper 1 auch ein anderes Leuchtmittel oder eine anders ausgestaltete Leuchtdiode 13 umfassen, die einen anderen Aufbau aufweist oder zur Abgabe von Licht in einem anderen Wellenlängenbereich ausgebildet ist.

Im gezeigten Ausführungsbeispiel ist der Kühlkörper 3 aus Kupfer ausgebildet, da Kupfer eine hohe Wärmeleitfähigkeit besitzt. Alternativ dazu kann der Kühlkörper bei allen Ausführungsformen einer erfindungsgemäßen Vorrichtung 100 aus einer Kupferlegierung oder anderen Materialien mit hoher Wärmeleitfähigkeit ausgebildet sein.

Der Kühlkörper 3 weist einen Vorsprung 33 auf, an dem der Kühlkörper 3 flächig mit der thermischen Kontaktfläche 11 des Beleuchtungskörpers 1 in Kontakt steht. Wie in Fig. 4 ersichtlich ist, ist der Vorsprung 33 in seiner Form und Höhe an die Form und Höhe der Ausnehmung 21 im Trägerelement 2 derart angepasst, dass er durch das Trägerelement 2 hindurchragt und an die thermische Kontaktfläche des Beleuchtungskörpers 1 geführt ist.

Die Form des Kühlkörpers 3 ist dabei im gezeigten Ausführungsbeispiel aus einem Halbzylinder- und einem Halbkegelstumpf zusammengesetzt, wobei der Kühlkörper 3 eine Anschlussstelle 31 zur Ausbildung einer stoffschlüssigen Verbindung aufweist. Die Anschlussstelle 31 befindet sich im vom Heißleiter 4 abgewandten Bereich des Kühlkörpers 3, sodass eine erfindungsgemäße Vorrichtung 100 problemlos beispielsweise durch Löten oder Kleben in größere Anlagen oder Geräte integriert werden kann.

Wie bereits zuvor erwähnt, ist der Heißleiter 4 mit dem Kühlkörper 3 wärmeleitend verbunden und gleichzeitig gegenüber dem Kühlkörper 3 elektrisch isoliert. Dies wird im gezeigten Ausführungsbeispiel dadurch erzielt, dass die Verbindung zwischen dem Heißleiter 4 und dem Kühlkörper 3 mittels eines wärmeleitenden und elektrisch isolierenden Verbindungsmittels hergestellt ist. Beim Verbindungsmittel handelt es sich im gezeigten Beispiel um einen Klebstoff wie z.B. ein Kunstharz, dass mit keramischen oder mineralischen Füllstoffen versetzt ist, sodass zwar Wärme über den Klebstoff geleitet wird, jedoch kein elektrischer Strom fließen kann. Derartige Klebstoffe bieten als weiteren Vorteil, dass sie eine hohe Temperaturbeständigkeit von beispielsweise bis zu 200°C aufweisen.

Werden nun bei Betrieb der Vorrichtung 100 die elektrischen Anschlüsse 12a, 12b des Beleuchtungskörpers 1 vom Strom durchflossen, erzeugt dieser UV-Licht in einem gewählten Wellenlängenbereich, wobei auch Wärmeenergie erzeugt wird. Da zu hohe Temperaturen die Lebensdauer von Leuchtdioden 13 drastisch verkürzen können bzw. auch dazu führen können, dass nicht mehr UV-Licht im gewünschten Wellenlängenbereich abgegeben wird, kontaktiert der Heißleiter 4 die elektrischen Anschlüsse 12a, 12b des Beleuchtungskörpers 1. Im kalten Zustand ist der Widerstand des Heißleiters 3 vergleichsweise hoch, nimmt aber mit steigender Temperatur entsprechend einer für den jeweiligen Heißleiter 4 charakteristischen Kennlinie weiter ab.

Erzeugt nun der Beleuchtungskörper 1 im Betrieb Wärmeenergie, so wird diese über die thermische Kontaktfläche 11 an den Kühlkörper 3 weitergeleitet. Der Kontakt an der thermischen Kontaktfläche 11 mit dem Kühlkörper 3 ist beispielsweise durch Löten hergestellt. Der Kühlkörper 3 ist mit dem Heißleiter 4 wärmeleitend verbunden, sodass die Temperatur des Heißleiters 4 zunimmt, wenn vom Beleuchtungskörper 1 Wärmeenergie erzeugt und an den Kühlkörper 3 geleitet wird. Auf diese Weise sinkt der Widerstand bzw. steigt die elektrische Leitfähigkeit des Heißleiters 4 entsprechend der Kennlinie des Heißleiters 4.

Besonders vorteilhaft für die Bestrahlung größerer Flächen mit Licht, insbesondere UV-Licht, zum Aushärten von strahlenhärtenden Substanzen, ist eine erfindungsgemäße Anordnung zur Abgabe von Licht umfassend eine Vielzahl von Vorrichtungen 100, eine Stromquelle zur Versorgung der Vorrichtungen 100 mit Strom und einen der Stromquelle nachgeschalteten Treiber. Auf diese Weise ist es beispielsweise möglich, bis zu 15 Vorrichtungen 100 in Serie zu schalten, wobei diese an den Treiber angeschlossen sind. Der Treiber stellt einen konstanten Stromfluss durch die Vorrichtungen 100 sicher. Die Beleuchtungsintensität kann mit einer derartigen Anordnung entsprechend verstärkt werden, sodass ein schnelleres Aushärten gewährleistet ist. Zusätzlich können auf diese Weise auch größere Flächenbereiche bestrahlt werden.

## Patentansprüche

1. Vorrichtung (100) zur Abgabe von Licht, insbesondere zum Aushärten von unter Einstrahlung von Licht, insbesondere UV-Licht, härtenden Substanzen, umfassend
- einen elektrischen Beleuchtungskörper (1) mit zumindest einer thermischen Kontaktfläche (11) und zumindest zwei elektrischen Anschlüssen (12a, 12b),
- wobei im Rahmen der Lichtabgabe entstehende Wärmeenergie über die thermische Kontaktfläche (11) ableitbar ist, und
- wobei der Beleuchtungskörper (1) auf ein Trägerelement (2) aufgebracht ist, und
- einen Kühlkörper
- wobei das Trägerelement (2) im Bereich der thermischen Kontaktfläche (11) des Beleuchtungskörpers (1) zumindest eine Ausnehmung (21) aufweist,
- wobei der Kühlkörper (3), mit der thermischen Kontaktfläche (11) des Beleuchtungskörpers (1) im Bereich der Ausnehmung (21) im Trägerelement (2) wärmeleitend verbunden ist, und
- wobei die Vorrichtung (100) einen Heißleiter (4) umfasst, der mit den elektrischen Anschlüssen (12a, 12b) des Beleuchtungskörpers (1) elektrisch leitend verbunden ist, wobei der Heißleiter (4) mit dem Kühlkörper (3) wärmeleitend verbunden und gleichzeitig gegenüber dem Kühlkörper (3) elektrisch isoliert ist,
**dadurch gekennzeichnet,**
**dass** das Trägerelement (2) zumindest zwei Durchlässe (23a, 23b) aufweist, wobei die zwei Kontakte, insbesondere Kontaktstifte (41a, 41b) des Heißleiters (4) durch die Durchlässe (23a, 23b) an die elektrischen Anschlüsse (12a, 12b) des Beleuchtungskörpers (1) geführt sind.

2. Vorrichtung (100) nach Anspruch 1, **dadurch gekennzeichnet, dass** der Beleuchtungskörper (1) eine Leuchtdiode (13) umfasst, die zur Abgabe von UV-Licht, insbesondere von UV-A-Licht, vorzugsweise in einem Wellenlängenbereich von 315 bis 380 nm, ausgebildet ist.

3. Vorrichtung (100) nach Anspruch 1 oder 2, **dadurch gekennzeichnet, dass** das Trägerelement (2) als Leiterplatte ausgebildet ist.

4. Vorrichtung (100) nach einem der vorangehenden Ansprüche, **dadurch gekennzeichnet, dass** der Kühlkörper (3) aus Kupfer oder einer Kupferlegierung ausgebildet ist.

5. Vorrichtung (100) nach einem der vorangehenden Ansprüche, **dadurch gekennzeichnet, dass** der Kühlkörper (3) zumindest eine Anschlussstelle (31) zur Ausbildung einer stoffschlüssigen Verbindung, insbesondere durch Löten oder Kleben, in seinem vom Heißleiter (4) abgewandten Bereich aufweist.

6. Vorrichtung (100) nach einem der vorangehenden Ansprüche, **dadurch gekennzeichnet, dass** die Verbindung zwischen dem Heißleiter (4) und dem Kühlkörper (3) mittels eines wärmeleitenden und elektrisch isolierenden Verbindungsmittels, insbesondere eines Klebstoffs, vorzugsweise eines hochtemperaturbeständigen wärmeleitfähigen Klebstoffs, hergestellt ist.

7. Vorrichtung (100) nach einem der vorangehenden Ansprüche, **dadurch gekennzeichnet, dass** der Kühlkörper (3) einen Vorsprung (33) aufweist, wobei der Vorsprung (33) in seiner Form und Höhe an die Form und Höhe der Ausnehmung (21) im Trägerelement (2) angepasst ist, sodass der Vorsprung (33) durch die Ausnehmung (21) hindurch an die thermische Kontaktfläche (11) des Beleuchtungskörpers (1) geführt ist und flächig mit der thermischen Kontaktfläche (11) in Kontakt steht.

8. Anordnung zur Abgabe von Licht, insbesondere zum Aushärten von unter Einstrahlung von Licht, insbesondere UV-Licht, härtenden Substanzen, umfassend
eine Vielzahl an Vorrichtungen (100) zur Abgabe von Licht nach einem der Ansprüche 1 bis 7, eine Stromquelle zur Versorgung der Vorrichtungen (100) mit Strom, und einen der Stromquelle nachgeschalteten Treiber,
wobei die Vorrichtungen (100) in Serie geschaltet und an den Treiber angeschlossen sind und wobei der Treiber dazu ausgebildet ist, einen konstanten Stromfluss durch die Vorrichtungen (100) einzustellen.

## Claims

1. Light-emitting device (100), in particular for the hardening of substances which harden when irradiated by light, in particular UV light, comprising:
- an electrical light fixture (1) with at least one heat contact surface (11) and at least two electrical connections (12a, 12b),
- wherein heat energy generated during the light emission can be dissipated over the heat contact surface (11),
- wherein the light fixture (1) is mounted on a support element (2),
- a heat sink
- wherein the support element (2) has at least one recess (21) in the area of the heat contact surface (11) of the light fixture (1),
- wherein the heat sink (3) is heat-conductively connected to the heat contact surface (11) of the light fixture (1) in the area of the recess (21) in the support element (2), and
- wherein the device (100) comprises a thermistor (4) which is electrically conductively connected to the electrical connections (12a, 12b) of the light fixture (1), wherein the thermistor (4) is heat-conductively connected to the heat sink (3) and at the same time is electrically insulated from the heat sink (3),
**characterized in that**
the support element (2) has at least two passages (23a, 23b), wherein the two contacts, in particular contact pins (41a, 41b) of the thermistor (4), are guided through the passages (23a, 23b) to the electrical connections (12a, 12b) of the light fixture (1).

2. Device (100) according to claim 1, **characterized in that** the light fixture (1) comprises a light-emitting diode (13) which is designed to emit UV light, in particular UV-A light, preferably in a wavelength range of 315 to 380 nm.

3. Device (100) according to claim 1 or 2, **characterized in that** the support element (2) is designed as a printed circuit board.

4. Device (100) according to any one of the preceding claims, **characterized in that** the heat sink (3) is made of copper or a copper alloy.

5. Device (100) according to any one of the preceding claims, **characterized in that** the heat sink (3) has at least one connection point (31) for forming a cohesive bond, in particular by brazing or gluing, in its area facing away from the thermistor (4).

6. Device (100) according to any one of the preceding claims, **characterized in that** the bond between the thermistor (4) and the heat sink (3) is made by means of a heat-conducting and electrically insulating bonding agent, in particular an adhesive, preferably a high-temperature-resistant, heat-conductive adhesive.

7. Device (100) according to any one of the preceding claims, **characterized in that** the heat sink (3) has a projection (33), wherein the projection (33) is adapted in its shape and height to the shape and height of the recess (21) in the support element (2), so that the projection (33) is guided through the recess (21) to the heat contact surface (11) of the light fixture (1) and is in flat contact with the heat contact surface (11).

8. Arrangement for emitting light, in particular for the hardening of substances which harden when irradiated by light, in particular UV light, comprising:
a plurality of light-emitting devices (100) according to any one of claims 1 to 7, a power source for supplying the devices (100) with power, and a driver connected downstream from the power source,
wherein the devices (100) are connected in series and connected to the driver, and wherein the driver is designed to adjust a constant power flow through the devices (100).

## Revendications

1. Dispositif (100) d'émission de lumière, en particulier pour durcir des substances durcissant par rayonnement de lumière, en particulier de lumière UV, comprenant
- un corps d'éclairage électrique (1) avec au moins une surface de contact thermique (11) et au moins deux raccords électriques (12a, 12b),
- dans lequel de l'énergie thermique générée dans le cadre de l'émission de lumière peut être dissipée par l'intermédiaire de la surface de contact thermique (11), et
- dans lequel le corps d'éclairage (1) est appliqué sur un élément de support (2), et
- un corps de refroidissement
- dans lequel l'élément de support (2) présente au moins un évidement (21) dans le zone de la surface de contact thermique (11) du corps d'éclairage (1),
- dans lequel le corps de refroidissement (3) est connecté de manière thermoconductrice à la surface de contact thermique (11) du corps d'éclairage (1) dans la zone de l'évidement (21) dans l'élément de support (2), et
- dans lequel le dispositif (100) comprend un thermistor (4) qui est connecté de manière électroconductrice aux raccords électriques (12a, 12b) du corps d'éclairage (1), dans lequel le thermistor (4) est connecté de manière thermoconductrice au corps de refroidissement (3) et est simultanément isolé électriquement par rapport au corps de refroidissement (3),
**caractérisé en ce que**
l'élément de support (2) présente au moins deux passages (23a, 23b), dans lequel les deux contacts, en particulier des broches de contact (41a, 41b) du thermistor (4), sont guidés à travers les passages (23a, 23b) vers les raccords électriques (12a, 12b) du corps d'éclairage (1).

2. Dispositif (100) selon la revendication 1, **caractérisé en ce que** le corps d'éclairage (1) comprend une diode électroluminescente (13) qui est conçue pour émettre de la lumière UV, en particulier de la lumière UV-A, de préférence dans une gamme de longueurs d'onde de 315 à 380 nm.

3. Dispositif (100) selon la revendication 1 ou 2, **caractérisé en ce que** l'élément de support (2) est conçu en tant que carte de circuit imprimé.

4. Dispositif (100) selon l'une quelconque des revendications précédentes, **caractérisé en ce que** le corps de refroidissement (3) est en cuivre ou en alliage de cuivre.

5. Dispositif (100) selon l'une quelconque des revendications précédentes, **caractérisé en ce que** le corps de refroidissement (3) présente au moins un point de raccordement (31) pour former une connexion par accouplement de matière, en particulier par soudage ou collage, dans sa zone opposée au thermistor (4).

6. Dispositif (100) selon l'une quelconque des revendications précédentes, **caractérisé en ce que** la connexion entre le thermistor (4) et le corps de refroidissement (3) est réalisée au moyen d'un moyen de connexion thermoconducteur et électriquement isolant, en particulier une colle, de préférence une colle thermoconductrice résistante aux températures élevées.

7. Dispositif (100) selon l'une quelconque des revendications précédentes, **caractérisé en ce que** le corps de refroidissement (3) présente une saillie (33), dans lequel la saillie (33) est adaptée au niveau de sa forme et sa hauteur à la forme et à la hauteur de l'évidement (21) dans l'élément de support (2), de sorte que la saillie (33) passe à travers l'évidement (21) jusqu'à la surface de contact thermique (11) du corps d'éclairage (1) et soit en contact à plat avec la surface de contact thermique (11).

8. Agencement d'émission de lumière, en particulier pour durcir des substances durcissant par rayonnement de lumière, en particulier de lumière UV, comprenant
une pluralité de dispositifs (100) pour émettre de la lumière selon l'une quelconque des revendications 1 à 7, une source de courant pour alimenter les dispositifs (100) en courant et un pilote en aval de la source de courant,
dans lequel les dispositifs (100) sont montés en série et raccordés au pilote, et dans lequel le pilote est conçu pour régler un flux de courant constant à travers les dispositifs (100).
